# EUROPEAN PATENT APPLICATION

(11) **EP 4 761 537 A1**
(43) Date of publication of application: **17.06.2026**
(21) Application number: 24858643.0
(22) Date of filing: 28.08.2024
(51) Int. Cl.: H10K 50/844

(54) **BONDING PACKAGING METHOD AND DISPLAY DEVICE**

(30) Priority: 28.08.2023 CN 202311090342
(71) Applicant: Suzhou Bearsunny Technologies Inc., Suzhou, Jiangsu 215211 (CN)
(72) Inventor: CHEN, Yeyue, Suzhou, Jiangsu 215211 (CN); ZHANG, Jing, Suzhou, Jiangsu 215211 (CN); JIANG, Yishan, Suzhou, Jiangsu 215211 (CN)
(74) Representative: Regimbeau
(86) International application number: PCT/CN2024/115264
(87) International publication number: WO 2025/045110

(57) **Abstract**

Provided are a bonding encapsulation method and a display device. The bonding encapsulation method includes: bonding an optically clear adhesive on a first surface of a first plate to form an optically clear adhesive layer, where a spacing exists between each outer edge of the optically clear adhesive layer and a respective outer edge of the first plate, and a size of the optically clear adhesive layer is smaller than a size of the first plate; dispensing and filling a sealant within the spacing to form a sealant layer to fill the spacing completely with the sealant layer; and bonding a second surface of a second plate to the optically clear adhesive layer and the sealant layer, where an orthographic projection of the second plate covers the optically clear adhesive layer and the sealant layer. The sealant layer is embedded between a substrate and a cover plate. An improvement is made from the absence of a sealing depth in a conventional technique to the setting of an encapsulation depth, improving the sealing effect of the display device and enhancing the stability and durability of the sealability of the product.

## Description

### CROSS-REFERENCE TO RELATED APPLICATION(S)

This application claims priority to Chinese Patent Application No. 202311090342.2 filed with the China National Intellectual Property Administration (CNIPA) on Aug. 28, 2023, the disclosure of which is incorporated herein by reference in its entirety.

### TECHNICAL FIELD

The present application relates to the field of display technology and, in particular, to a bonding encapsulation method and a display device.

### BACKGROUND

With the development of display technology, bonding encapsulation techniques for display devices have also developed. In conventional techniques, the bonding encapsulation of a display device typically includes fully applying an optically clear adhesive (OCA) to a substrate and/or a cover plate, and then coating a sealant on outer sidewalls of the substrate and the cover plate.

However, in the display device bonded and encapsulated by the above method, the sealant can only be in contact with outer side portions of the product, resulting in a poor sealing effect. A sealing failure is likely to occur, affecting the quality of the display device and the subsequent use effect.

### SUMMARY

For the problem where the sealant can only be in contact with outer side portions of a product, it is necessary to provide a bonding encapsulation method and a display device.

In a first aspect, an embodiment of the present application provides a bonding encapsulation method. The bonding encapsulation method includes: bonding an optically clear adhesive on a first surface of a first plate to form an optically clear adhesive layer, where a spacing exists between each outer edge of the optically clear adhesive layer and a respective outer edge of the first plate, and a size of the optically clear adhesive layer is smaller than a size of the first plate; dispensing and filling a sealant within the spacing to form a sealant layer to fill the spacing completely with the sealant layer; and bonding a second surface of a second plate to the optically clear adhesive layer and the sealant layer, where an orthographic projection of the second plate covers the optically clear adhesive layer and the sealant layer.

In the bonding encapsulation method according to the embodiment of the present application, the first plate may be configured to be one of a substrate and a cover plate, and the second plate may be configured to be the other of the substrate and the cover plate. The optically clear adhesive layer adhesively bonds the substrate to the cover plate, and the sealant layer sealingly connects the substrate, the optically clear adhesive layer, and the cover plate, to achieve a sealing encapsulation effect. Compared with a conventional technique in which the optically clear adhesive layer is fully applied to the substrate and/or the cover plate and the sealant layer can only be coated on outer sidewalls of the substrate and the cover plate, the sealant layer in the present application is embedded between the substrate and the cover plate. Thus, an improvement is made from the absence of a sealing depth in the conventional technique to the setting of an encapsulation depth, improving the sealing effect of a display device and enhancing the stability and durability of the sealability of the product.

In an embodiment, dispensing and filling the sealant within the spacing to form the sealant layer includes: acquiring a pattern of the spacing, and formulating a dispensing path according to the pattern; and dispensing the sealant within the spacing along the dispensing path to form the sealant layer such that the height of the sealant layer is greater than or equal to the height of the optically clear adhesive layer.

In an embodiment, the dispensing path includes at least multiple path segments extending circumferentially, adjacent two path segments of the multiple path segments are connected to form the continuous dispensing path, and the adjacent two path segments are spaced apart along an inward-outward direction.

Alternatively, the dispensing path includes at least multiple first paths and multiple second paths, an extension line of a first path among the multiple first paths intersects an extension line of an adjacent second path among the multiple second paths, and the first path and the adjacent second path are connected end to end.

At least part of the multiple path segments or the multiple first paths or the multiple second paths are arranged against outer edges of the optically clear adhesive layer and outer edges of the first surface of the first plate.

Filling the spacing completely with the sealant layer includes: dispensing the sealant along the dispensing path, and covering the dispensing path with a dispensed adhesive bead such that the formed sealant layer is bonded to the outer edges of the optically clear adhesive layer and the first surface of the first plate.

In an embodiment, a size of the dispensed adhesive bead is greater than or equal to a spacing between the adjacent two path segments.

Alternatively, a size of the dispensed adhesive bead is greater than or equal to the distance between the first path and the adjacent second path.

In an embodiment, when the dispensing within the spacing is completed, the sealant layer fills the spacing in a first state; and the method further includes: before bonding the second plate, pre-forming the sealant layer such that the sealant layer fills the spacing in a second state, where the hardness of the sealant layer in the second state is greater than the hardness of the sealant layer in the first state.

In an embodiment, the method further includes: after bonding the second plate, curing the sealant layer such that the sealant layer is presented in a third state, where the hardness of the sealant layer in the third state is greater than the hardness of the sealant layer in the second state.

In an embodiment, the sealant layer includes an ultraviolet (UV) adhesive.

The pre-forming includes irradiating the UV adhesive with a UV curing lamp such that the UV adhesive is in the second state.

In a second aspect, an embodiment of the present application provides a display device manufactured by the bonding encapsulation method according to any one of the preceding embodiments. The display device includes a first plate, a second plate, and an optically clear adhesive layer.

The optically clear adhesive layer is disposed between the first plate and the second plate, a first bonding surface and a second bonding surface of the optically clear adhesive layer are bonded to the first plate and the second plate respectively, and the first bonding surface and the second bonding surface are opposite to each other.

A spacing exists between each outer edge of the optically clear adhesive layer and respective outer edges of the first plate and the second plate, and orthographic projections of the first plate and the second plate cover the optically clear adhesive layer.

The display device further includes a sealant layer filled within the spacing, where the sealant layer completely fills the spacing.

In the display device, the first plate may be configured to be one of a substrate and a cover plate, and the second plate may be configured to be the other of the substrate and the cover plate. The optically clear adhesive layer adhesively bonds the substrate to the cover plate, and the sealant layer sealingly connects the substrate, the optically clear adhesive layer, and the cover plate, to achieve a sealing encapsulation effect. Compared with a conventional technique in which the optically clear adhesive layer is fully applied to the substrate and/or the cover plate and the sealant layer can only be coated on outer sidewalls of the substrate and the cover plate, the sealant layer in the present application is embedded between the substrate and the cover plate. Thus, an improvement is made from the absence of a sealing depth in the conventional technique to the setting of an encapsulation depth, improving the sealing effect of the display device and enhancing the stability and durability of the sealability of the product.

In an embodiment, the spacing is greater than or equal to 0.1 mm.

In an embodiment, the center of the optically clear adhesive layer exactly or substantially coincides with the centers of the first plate and the second plate.

Alternatively, the optically clear adhesive layer has a hollow portion, and the center of the hollow portion exactly or substantially coincides with the centers of the first plate and the second plate.

### BRIEF DESCRIPTION OF DRAWINGS

FIG. 1 is a flowchart of a bonding encapsulation method according to an embodiment of the present application.
FIG. 2 is a schematic diagram during manufacturing of a display device by a bonding encapsulation method according to an embodiment of the present application.
FIG. 3 is a diagram illustrating dispensing in a bonding encapsulation method according to an embodiment of the present application.
FIG. 4 is an enlarged view of part A in FIG. 3.
FIG. 5 is a diagram illustrating a dispensing path during manufacturing of a display device by a bonding encapsulation method according to an embodiment of the present application.
FIG. 6 is another diagram illustrating a dispensing path during manufacturing of a display device by a bonding encapsulation method according to an embodiment of the present application.
FIG. 7 is a schematic diagram after bonding of a second plate in a bonding encapsulation method according to an embodiment of the present application.
FIG. 8 is a diagram illustrating pre-forming of a sealant layer in a bonding encapsulation method according to an embodiment of the present application.
FIG. 9 is a diagram illustrating the structure of a display device according to an embodiment of the present application.
FIG. 10 is a diagram illustrating the structure of a display device provided with a hollow portion according to an embodiment of the present application.

### Reference list:

- 100: display device
- 10: first plate
- 11: first surface
- 20: optically clear adhesive layer
- 21: first bonding surface
- 22: second bonding surface
- 23: hollow portion
- 30: sealant layer
- 40: second plate
- 41: second surface
- 50: dispensing path
- 51: first path
- 52: second path
- 200: UV curing lamp
- 300: dispenser

### DETAILED DESCRIPTION

To facilitate understanding of the present application, a more complete description of the present application is provided below with reference to the drawings. The drawings illustrate preferred embodiments of the present application. However, the present application may be implemented in many different forms and is not limited to the embodiments described herein. Conversely, these embodiments are provided for a more thorough and complete understanding of the content disclosed in the present application.

It is to be noted that when an element is described as being "fixed to" another element, the element may be directly on the particular element, or an intervening element may be present. When an element is considered as being "connected to" another element, the element may be directly connected to the particular element, or an intervening element may be present. The terms such as "vertical", "horizontal", "left", and "right" used herein are for illustrative purposes.

Spatially related terms such as "upper portion" and "lower portion" herein are defined with reference to the drawings. Therefore, it is to be understood that the "upper portion" and the "lower portion" are interchangeable. It is to be understood that when a layer is described as being "on" another layer, the layer may be directly formed on the particular layer, or an intermediate layer may be present. Therefore, it is to be understood that when a layer is described as being "directly on" another layer, no intermediate layer is inserted therebetween.

In the drawings, sizes of a layer and a region may be exaggerated for clear illustration. It is to be understood that when a layer or element is described as being "on" another layer or a substrate, the layer or element may be directly on the particular layer or the substrate, or an intermediate layer may be present. Moreover, it is to be understood that when a layer is described as being "between" two layers, the layer may be a unique layer between the two layers, or one or more intermediate layers may be present. Additionally, the same reference numerals represent the same elements throughout the drawings.

Terms such as "first" and "second" may be used below to describe various components and are not intended to limit such components. These terms are used to distinguish one component from another. It is to be understood that an expression in a singular form includes a plural form unless the expression in the singular form has a distinct meaning in the context. Additionally, it is to be understood that terms "including" and/or "having" used in the following embodiments indicate the presence of the described features or components and do not exclude the presence or addition of one or more other features or components.

In the following embodiments, when a layer, region, or element is "connected", it may be interpreted that the layer, region, or element is either directly connected or connected via another intervening element. For example, when a layer, region, element, etc. is described as being connected or electrically connected, the layer, region, element, etc. may be directly connected or directly and electrically connected or may be connected or electrically connected via another intervening layer, region, element, etc.

The term "and/or" used in application documents indicates the inclusion of any combination or all combinations of one or more listed associated items. When an expression such as "at least one of ..." precedes a list of elements, the expression modifies the entire list of elements rather than individual elements in the list.

Unless otherwise defined, all technical and scientific terms used herein have the same meanings as those commonly understood by those skilled in the art to which the present application pertains. The terms used in the specification of the present application are intended to describe embodiments and not to limit the present application. The term "and/or" used herein indicates the inclusion of any combination or all combinations of one or more listed associated items.

It is to be understood that terms such as "comprising/including" and "having" specify the presence of the described features, entireties, steps, operations, components, parts, or combinations thereof and do not exclude the possibility of the presence or addition of one or more other features, entireties, steps, operations, components, parts, or combinations thereof.

An electronic or electrical device and/or any other related device or component according to embodiments of the concepts of the present application described herein (such as a display device including a display panel and a display panel driver, where the display panel driver includes a drive controller, a gate driver, a gamma reference voltage generator, a data driver, and an emission driver) may be implemented by any appropriate hardware, firmware (such as an application-specific integrated circuit), software, or combination of software, firmware, and hardware. For example, various components of such devices may be formed on one integrated circuit (IC) chip or on separate IC chips. Alternatively, various components of such devices may be implemented on a flexible printed circuit film, a tape carrier package (TCP), or a printed circuit board (PCB) or formed on a substrate. Alternatively, various components of such devices may be processes or threads that run on one or more processors in one or more computing devices to execute computer program instructions and interact with other system components to implement various functions described herein. The computer program instructions are stored in a memory, where the memory may be implemented in a computing device using a standard storage device (such as a random-access memory (RAM)). Alternatively, the computer program instructions may be stored in another non-transitory computer-readable medium (such as a compact disc read-only memory (CD-ROM) or a flash drive). Moreover, those skilled in the art should appreciate that functions of various computing devices may be combined or integrated into a single computing device, or functions of a particular computing device may be distributed on one or more other computing devices without departing from the spirit and scope of example embodiments of the concepts of the present application.

Although example embodiments of a display module and a display device including the display module are particularly described herein, many modifications and variations are apparent to those skilled in the art. Therefore, it is to be understood that the display module and the display device including the display module, which are constructed according to the principles of the present application, may be implemented in other manners than those particularly described herein. The present application is defined in the claims and equivalents thereof.

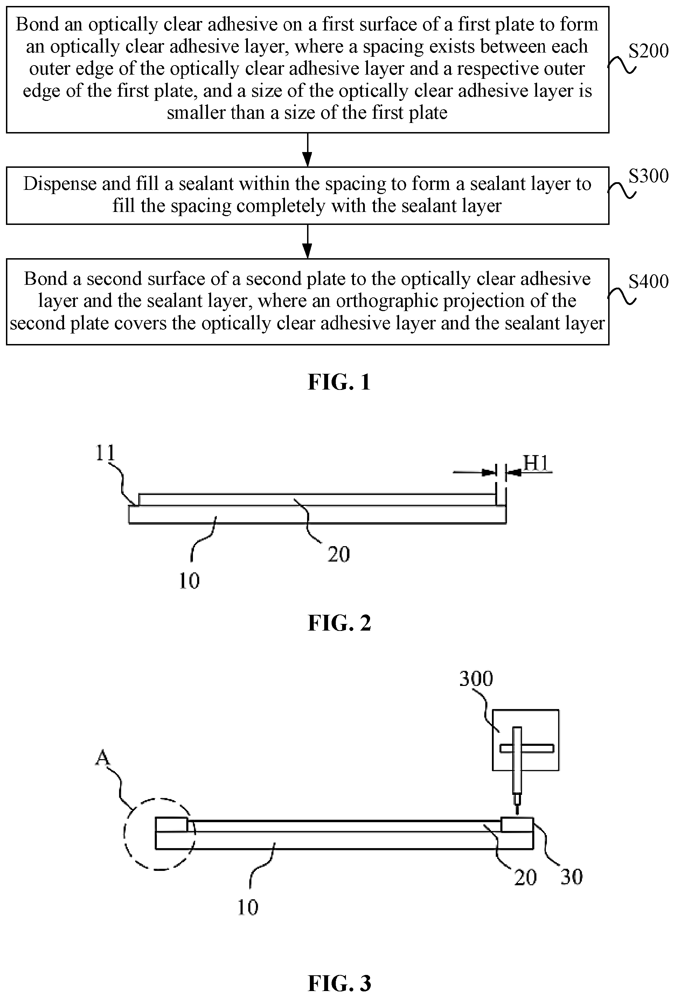

Referring to FIG. 1 in conjunction with FIGS. 2, 3, and 7, FIG. 1 is a flowchart of a bonding encapsulation method according to an embodiment of the present application.

At least one embodiment disclosed in the present application provides a bonding encapsulation method. The bonding encapsulation method includes S200 to S400.

In S200, an optically clear adhesive is bonded on a first surface 11 of a first plate 10 to form an optically clear adhesive layer 20, where a spacing exists between each outer edge of the optically clear adhesive layer 20 and a respective outer edge of the first plate 10, and the size of the optically clear adhesive layer 20 is smaller than the size of the first plate 10.

In S300, a sealant is dispensed and filled within the spacing to form a sealant layer 30 such that the spacing is completely filled with the sealant layer 30.

In S400, a second surface 41 of a second plate 40 is bonded to the optically clear adhesive layer 20 and the sealant layer 30, where an orthographic projection of the second plate 40 covers the optically clear adhesive layer 20 and the sealant layer 30.

In the bonding encapsulation method according to the embodiment of the present application, the first plate 10 may be configured to be one of a substrate and a cover plate, and the second plate 40 may be configured to be the other of the substrate and the cover plate. The optically clear adhesive layer 20 is shrunk inward in size relative to the first surface 11 of the first plate 10 such that after the optically clear adhesive layer 20 is bonded to the center position of the first surface 11, edges of the first surface 11 are exposed for the bonding of the sealant layer 30. The optically clear adhesive layer 20 adhesively bonds the substrate to the cover plate, and the sealant layer 30 sealingly connects the substrate, the optically clear adhesive layer 20, and the cover plate, to achieve a sealing encapsulation effect. Compared with a conventional technique in which the optically clear adhesive layer 20 is fully applied to the substrate and/or the cover plate and the sealant layer 30 can only be coated on outer sidewalls of the substrate and the cover plate, the sealant layer 30 in the present application is embedded between the substrate and the cover plate. Thus, an improvement is made from the absence of a sealing depth in the conventional technique to the setting of an encapsulation depth, improving the sealing effect of a display device 100 and enhancing the stability and durability of the sealability of the product.

Moreover, no adhesive coating or covering exists on the sidewalls of the first plate 10 and the second plate 40 in the display device 100 obtained by the bonding encapsulation method according to the embodiment of the present application so that while the stability and durability of the sealability of the display device 100 are ensured, the sidewalls of the first plate 10 and the second plate 40 are left exposed, making it more convenient to coat another adhesive or assemble other parts on the sidewalls of the first plate 10 and the second plate 40 in a process of further manufacturing the display device 100 to form another product.

FIG. 2 is a schematic diagram during manufacturing of a display device 100 by a bonding encapsulation method according to an embodiment of the present application. Referring to FIG. 2, in some embodiments, the spacing between each outer edge of the optically clear adhesive layer 20 and the respective outer edge of the first plate 10 is H1.

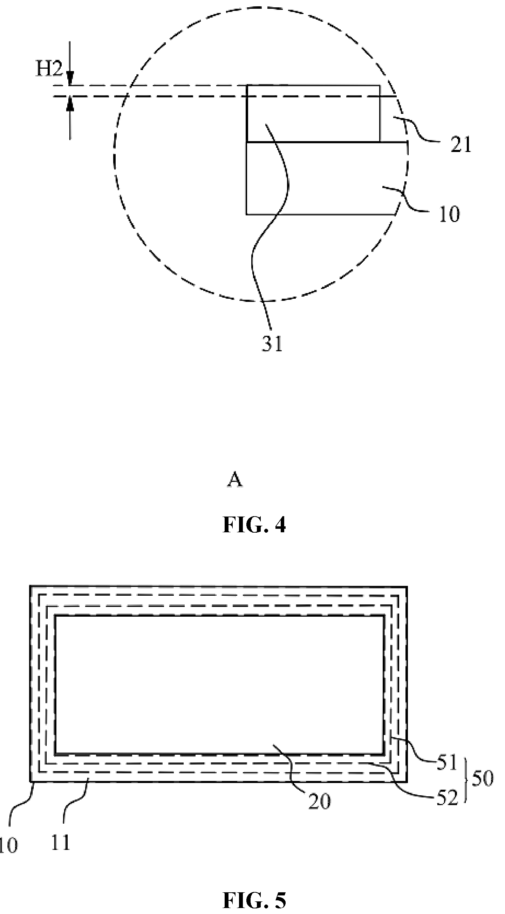

Referring to FIGS. 3 and 4, FIG. 3 is a diagram illustrating dispensing in a bonding encapsulation method according to an embodiment of the present application. FIG. 4 is an enlarged view of part A in FIG. 3. In some embodiments, S300 of dispensing and filling the sealant within the spacing to form the sealant layer 30 includes S310 and S320.

In S310, a pattern of the spacing is acquired, and a dispensing path 50 is formulated according to the pattern.

In S320, the sealant is dispensed within the spacing along the dispensing path 50 to form the sealant layer 30 such that the height of the sealant layer 30 is greater than or equal to the height of the optically clear adhesive layer 20.

The dispensing may be completed by a dispenser 300 or manually. The dispensing path 50 may be determined through CAD software drawing guidance or manual tracing. During the dispensing with the dispenser 300, after the dispensing path 50 is determined, the dispenser 300 is placed above a pre-dispensing position of the sealant, dispenses the sealant vertically on the first surface 11 of the first plate 10, and performs the dispensing along the dispensing path 50.

In the bonding encapsulation method of the embodiment of the present application, since an effective sealing connection area and the encapsulation depth of the sealant layer 30 are increased, a chemical type of the sealant is limited to a smaller degree, a lower requirement is imposed on the weather resistance of the sealant, and comprehensive requirements on the sealant are lowered so that the sealant satisfying sealing requirements is easier to select, and the production difficulty and cost are reduced.

Referring to FIG. 4, in some embodiments, the height of the sealant layer 30 is greater than the height of the optically clear adhesive layer 20, and a height difference is H2.

Referring to FIG. 5, FIG. 5 is a diagram illustrating a dispensing path 50 during manufacturing of a display device 100 by a bonding encapsulation method according to an embodiment of the present application. In some embodiments, the dispensing path 50 includes at least multiple path segments extending circumferentially, adjacent two path segments are connected to form the continuous dispensing path 50, and adjacent two path segments are spaced apart along an inward-outward direction. That is, the dispensing path 50 is a rectangular loop path.

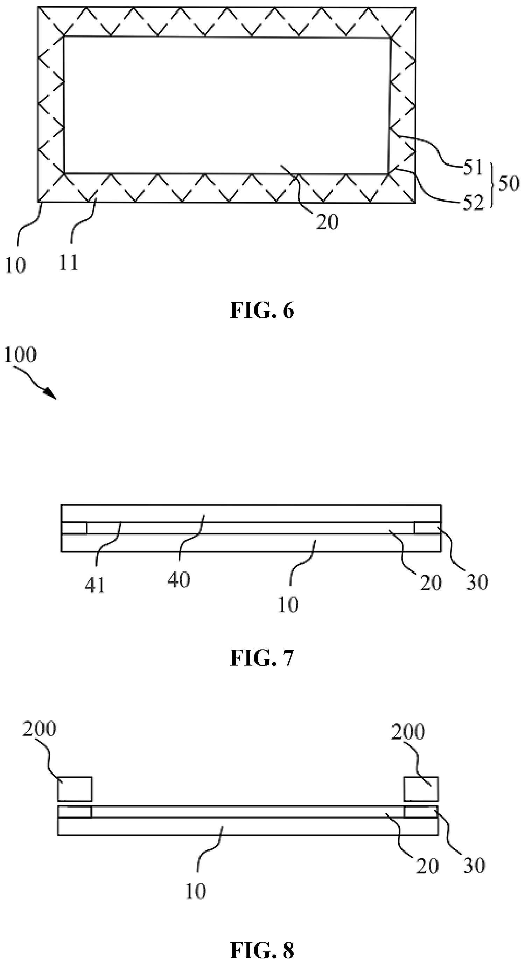

Referring to FIG. 6, FIG. 6 is another diagram illustrating a dispensing path 50 during manufacturing of a display device 100 by a bonding encapsulation method according to an embodiment of the present application. In some embodiments, the dispensing path 50 includes at least multiple first paths 51 and multiple second paths 52, an extension line of each first path 51 intersects an extension line of an adjacent second path 52, and the first path 51 and the adjacent second path 52 are connected end to end. That is, the dispensing path 50 is a zigzag path. It is to be understood that the dispensing path 50 may be designed in other shapes according to specific circumstances.

At least part of the multiple path segments or the multiple first paths 51 or the multiple second paths 52 are arranged against the outer edges of the optically clear adhesive layer 20 and the outer edges of the first surface 11 of the first plate 10. Filling the spacing completely with the sealant layer 30 includes the following:

The sealant is dispensed along the dispensing path 50, and the dispensing path 50 is covered with a dispensed adhesive bead such that the formed sealant layer 30 is bonded to the outer edges of the optically clear adhesive layer 20 and the first surface 11 of the first plate 10.

In some embodiments, a size of the dispensed adhesive bead is greater than or equal to a spacing between the adjacent two path segments; or a size of the dispensed adhesive bead is greater than or equal to the distance between the first path 51 and the adjacent second path 52.

In some embodiments, the bonding encapsulation method further includes the following:

When the dispensing within the spacing is completed, the sealant layer 30 fills the spacing in a first state.

Before the second plate 40 is bonded, the sealant layer 30 is pre-formed such that the sealant layer 30 fills the spacing in a second state, where the hardness of the sealant layer 30 in the second state is greater than the hardness of the sealant layer 30 in the first state.

The second state of the sealant layer 30 refers to an initial solid state of the sealant layer 30, which does not affect the bonding performance of the sealant layer 30 with the second plate and can ensure the sealability between the sealant layer and the second plate bonded subsequently.

Specifically, before the second plate 40 is bonded, the sealant layer 30 is pre-formed such that the sealant layer 30 transforms from the first state to the second state, that is, the hardness of the sealant layer 30 increases. During the bonding of the second plate 40, internal air pressure generated between the second plate 40 and the first plate 10 causes an air pressure impact on the sealant layer 30. Therefore, the sealant layer 30 is pre-formed so that the sealant layer 30 is pre-cured, thereby increasing the overall hardness of the sealant layer 30 and transforming the sealant layer 30 into the second state with sufficient strength to resist the internal air pressure generated between the second plate 40 and the first plate 10 and reduce a structural deformation of the sealant layer 30 due to the air pressure.

Referring to FIG. 7, FIG. 7 is a schematic diagram after bonding of a second plate 40 in a bonding encapsulation method according to an embodiment of the present application. In some embodiments, the bonding encapsulation method further includes: after bonding the second plate 40, curing the sealant layer 30 such that the sealant layer 30 is presented in a third state, where the hardness of the sealant layer 30 in the third state is greater than the hardness of the sealant layer 30 in the second state. The sealant layer 30 has an optimal bonding ability in the third state.

Specifically, after the first plate 10 is bonded, the display device is heated or placed in a high-temperature environment to increase the hardness of the sealant layer 30.

Referring to FIG. 8, FIG. 8 is a diagram illustrating pre-forming of a sealant layer 30 in a bonding encapsulation method according to an embodiment of the present application. In some embodiments, the sealant layer 30 includes a UV (ultraviolet rays) adhesive; and the pre-forming includes irradiating the UV adhesive with a UV curing lamp 200 such that the UV adhesive is in the second state.

Specifically, the irradiation of the UV curing lamp 200 may activate a photo-initiator in the UV adhesive to initiate a polymerization reaction, thereby pre-forming the UV adhesive, that is, pre-forming the sealant layer 30. It is to be understood that a type, a wavelength band, and parameters of the UV curing lamp 200 are selected and set according to the characteristics of the UV adhesive selected as the sealant. The pre-forming here is to increase the strength of the UV adhesive instead of completely drying the UV adhesive, to enable the UV adhesive to retain a certain viscosity to be sealingly connected to the subsequent second plate 40 and achieve an encapsulation effect.

In some embodiments, to pre-form the sealant layer 30, the UV curing lamp 200 may be configured to be a frame-shaped light source similar to the sealant layer 30 or may be configured with several light bars such that the UV curing lamp 200 irradiates the UV adhesive from above the UV adhesive to perform the pre-forming. Thus, the UV curing lamp 200 can precisely irradiate the UV adhesive that requires UV irradiation and avoid irradiation on the optically clear adhesive layer 20 as far as possible so that the optically clear adhesive layer 20 maintains a bonding viscosity to ensure a bonding effect for the subsequent second plate 40.

It is to be understood that, in some embodiments, when the optically clear adhesive layer 20 is selected, an optically clear adhesive layer 20 without photoinitiator is selected so that the optically clear adhesive layer 20 cannot be cured due to the irradiation of the UV curing lamp 200, thereby essentially avoiding an effect of the UV curing lamp 200 on the optically clear adhesive layer 20 during the pre-forming of the UV adhesive.

In some embodiments, to perform the subsequent curing on the UV adhesive, the height difference is set in advance when the UV adhesive is dispensed at the early stage so that the UV adhesive has a higher height before the pre-forming, leaving a total allowance for shrinkage caused by the subsequent pre-forming and curing.

Specifically, before the pre-forming of the UV adhesive, the height difference H2 exists between the surface of the UV adhesive facing away from the first plate 10 and the surface of the optically clear adhesive layer 20 facing away from the first plate 10 (with reference to FIG. 4). After the UV adhesive is irradiated by the UV curing lamp 200, the surface of the UV adhesive facing away from the first plate 10 shrinks to a position substantially flush with the surface of the optically clear adhesive layer 20 facing away from the first plate 10, thus improving the flatness of bonding.

It is to be understood that the irradiation of the UV curing lamp 200 activates the photoinitiator in the UV adhesive to initiate a polymerization reaction. Heat is released during the polymerization reaction, and thus the volume of a polymer decreases, resulting in shrinkage. Moreover, heat is also generated during irradiation for curing the UV adhesive, and thus the temperature around the UV adhesive increases. When the ambient temperature is too high or a light source is too strong, more heat is generated during the curing, exacerbating the shrinkage caused by polymerization shrinkage. Therefore, to alleviate the shrinkage caused by the pre-forming of the UV adhesive, the height difference is set in advance when the UV adhesive is dispensed so that the UV adhesive has a higher height before the pre-forming, leaving an allowance for the subsequent shrinkage. It is to be understood that the height difference may be selected and set according to the type, wavelength band, and parameters of the UV curing lamp 200 and the characteristics of the UV adhesive.

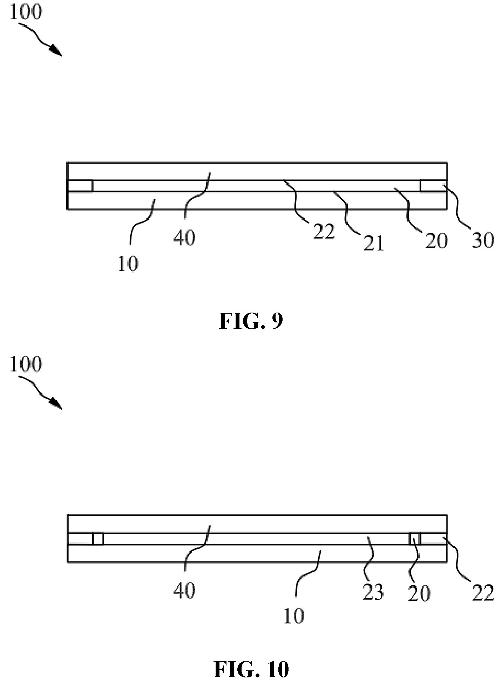

Referring to FIG. 9, FIG. 9 is a diagram illustrating the structure of a display device 100 according to an embodiment of the present application.

At least one embodiment disclosed in the present application provides a display device 100 manufactured by the bonding encapsulation method according to any one of the preceding embodiments. The display device 100 includes a first plate 10, a second plate 40, and an optically clear adhesive layer 20 disposed between the first plate 10 and the second plate 40; a first bonding surface 21 and a second bonding surface 22 of the optically clear adhesive layer 20 are bonded to the first plate 10 and the second plate 40 respectively, and the first bonding surface 21 and the second bonding surface 22 are opposite to each other. In conjunction with FIG. 3, a spacing exists between each outer edge of the optically clear adhesive layer 20 and the respective outer edges of the first plate 10 and the second plate 40, and orthographic projections of the first plate 10 and the second plate 40 cover the optically clear adhesive layer 20. The display device 100 further includes a sealant layer 30 filled within the spacing, where the sealant layer 30 completely fills the spacing.

In the display device 100, the first plate 10 may be configured to be one of a substrate and a cover plate, and the second plate 40 may be configured to be the other of the substrate and the cover plate. The optically clear adhesive layer 20 adhesively bonds the substrate to the cover plate, and the sealant layer 30 sealingly connects the substrate, the optically clear adhesive layer 20, and the cover plate, to achieve a sealing encapsulation effect. Compared with a conventional technique in which the optically clear adhesive layer 20 is fully applied to the substrate and/or the cover plate and the sealant layer 30 can only be coated on outer sidewalls of the substrate and the cover plate, the sealant layer 30 in the present application is embedded between the substrate and the cover plate. Thus, an improvement is made from the absence of a sealing depth in the conventional technique to the setting of an encapsulation depth, improving the sealing effect of the display device 100 and enhancing the stability and durability of the sealability of the product.

In some embodiments, the spacing is greater than or equal to 0.1 mm. Since the sealant layer 30 is filled within the spacing and completely fills the spacing, a width dimension of the sealing connection between the sealant layer 30 and the first plate 10 is greater than or equal to 0.1 mm, and a width dimension of the sealing connection between the sealant layer 30 and the second plate 40 is greater than or equal to 0.1 mm. Compared with the conventional technique in which the sealant layer is sealingly connected to the sidewalls of the first plate 10 and the second plate 40, the sealant layer 30 in the present application is embedded between the substrate and the cover plate. An improvement is made from the absence of the sealing depth in the conventional technique to the setting of the encapsulation depth, improving the sealing effect of the display device 100 and enhancing the stability and durability of the sealability of the product.

In some embodiments, the center of the optically clear adhesive layer 20 exactly or substantially coincides with the centers of the first plate 10 and the second plate 40.

Referring to FIG. 10, FIG. 10 is a diagram illustrating the structure of a display device 100 provided with a hollow portion 23 according to an embodiment of the present application. In some embodiments, the optically clear adhesive layer 20 has the hollow portion 23, and the center of the hollow portion 23 exactly or substantially coincides with the centers of the first plate 10 and the second plate 40. It is to be understood that the optically clear adhesive layer 20 may be a whole-piece optically clear adhesive layer 20 or a frame-shaped optically clear adhesive layer 20. The frame-shaped optically clear adhesive layer 20 has the hollow portion 23 at the center so that a gap exists at the center after the first plate 10 and the second plate 40 are bonded, and the first plate 10 and the second plate 40 are not in direct contact with each other.

The technical features in the preceding embodiments may be combined in any manner. For brevity of description, not all possible combinations of the technical features in the preceding embodiments are described. However, as long as the combinations of such technical features do not conflict, such combinations shall be considered within the scope of the specification.

The preceding embodiments illustrate several implementations of the present application, and the specific and detailed description thereof cannot be construed as limiting the scope of the patent application. It is to be noted that those of ordinary skill in the art can make several variations and improvements without departing from the concept of the present application, and such variations and improvements are within the scope of the present application. Therefore, the scope of the present application is defined by the appended claims.

## Claims

1. A bonding encapsulation method, comprising:
bonding an optically clear adhesive on a first surface of a first plate to form an optically clear adhesive layer, wherein a spacing exists between each outer edge of the optically clear adhesive layer and a respective outer edge of the first plate, and a size of the optically clear adhesive layer is smaller than a size of the first plate;
dispensing and filling a sealant within the spacing to form a sealant layer to fill the spacing completely with the sealant layer; and
bonding a second surface of a second plate to the optically clear adhesive layer and the sealant layer, wherein an orthographic projection of the second plate covers the optically clear adhesive layer and the sealant layer.

2. The bonding encapsulation method according to claim 1, wherein dispensing and filling the sealant within the spacing to form the sealant layer comprises:
acquiring a pattern of the spacing, and formulating a dispensing path according to the pattern; and
dispensing the sealant within the spacing along the dispensing path to form the sealant layer such that a height of the sealant layer is greater than or equal to a height of the optically clear adhesive layer.

3. The bonding encapsulation method according to claim 2, wherein the dispensing path comprises at least a plurality of path segments extending circumferentially, adjacent two path segments of the plurality of path segments are connected to make the dispensing path continuous, and the adjacent two path segments are spaced apart along an inward-outward direction; or
the dispensing path comprises at least a plurality of first paths and a plurality of second paths, an extension line of a first path among the plurality of first paths intersects an extension line of an adjacent second path among the plurality of second paths, and the first path and the adjacent second path are connected end to end;
at least part of the plurality of path segments or the plurality of first paths or the plurality of second paths are arranged against outer edges of the optically clear adhesive layer and outer edges of the first surface of the first plate; and
filling the spacing completely with the sealant layer comprises:
dispensing the sealant along the dispensing path, and covering the dispensing path with a dispensed adhesive bead such that the formed sealant layer is bonded to the outer edges of the optically clear adhesive layer and the first surface of the first plate.

4. The bonding encapsulation method according to claim 3, wherein a size of the dispensed adhesive bead is greater than or equal to a spacing between the adjacent two path segments; or
a size of the dispensed adhesive bead is greater than or equal to a distance between the first path and the adjacent second path.

5. The bonding encapsulation method according to 2, wherein the bonding encapsulation method further comprises:
when the dispensing within the spacing is completed, the sealant layer fills the spacing in a first state; and
before bonding the second plate, pre-forming the sealant layer such that the sealant layer fills the spacing in a second state, wherein a hardness of the sealant layer in the second state is greater than a hardness of the sealant layer in the first state.

6. The bonding encapsulation method according to 5, further comprising:
after bonding the second plate, curing the sealant layer such that the sealant layer is in a third state, wherein a hardness of the sealant layer in the third state is greater than the hardness of the sealant layer in the second state.

7. The bonding encapsulation method according to 5, wherein the sealant layer comprises an ultraviolet, UV, adhesive; and
the pre-forming comprises irradiating the UV adhesive with a UV curing lamp such that the UV adhesive is in the second state.

8. A display device manufactured by the bonding encapsulation method according to any one of claims 1 to 7, the display device comprising:
the first plate;
the second plate; and
the optically clear adhesive layer disposed between the first plate and the second plate, wherein a first bonding surface and a second bonding surface of the optically clear adhesive layer are bonded to the first plate and the second plate respectively, and the first bonding surface and the second bonding surface are opposite to each other;
wherein the spacing exists between each outer edge of the optically clear adhesive layer and respective outer edges of the first plate and the second plate, and orthographic projections of the first plate and the second plate each cover the optically clear adhesive layer; and
the display device further comprises the sealant layer filled within the spacing, wherein the sealant layer completely fills the spacing.

9. The display device according to claim 8, wherein the spacing is greater than or equal to 0.1 mm.

10. The display device according to claim 8, wherein a center of the optically clear adhesive layer exactly or substantially coincides with centers of the first plate and the second plate; or
the optically clear adhesive layer has a hollow portion, and a center of the hollow portion exactly or substantially coincides with centers of the first plate and the second plate.
